# EUROPEAN PATENT APPLICATION

(11) **EP 4 530 606 A1**
(43) Date of publication of application: **02.04.2025**
(21) Application number: 23199747.9
(22) Date of filing: 26.09.2023
(51) Int. Cl.: G01N 21/17, G01L 1/24

(54) **SEMICONDUCTOR DEVICES, MICROELECTROMECHANICAL SYSTEM GAS SENSOR, METHODS**

(71) Applicant: Infineon Technologies AG, 85579 Neubiberg (DE)
(72) Inventor: HAUFF, Michael, München 81379 (DE); TUMPOLD, David, 85551 Kirchheim bei München (DE); MITTEREDER, Tobias, 81369 München (DE); GHADERI, Mohammadamir, 93047 Regensburg (DE); HAMPL, Stefan, 01129 Dresden (DE); SIGL, Alfred, 93161 Sinzing (DE); SCHWÄGERL, Sebastian, 93413 Cham (DE)
(74) Representative: 2SPL Patentanwälte PartG mbB

(57) **Abstract**

Examples provide a semiconductor device. The semiconductor device comprises a radiation element and a detection element. The radiation element comprises a radiation layer for radiating an electromagnetic wave. The detection element comprises a detection layer for detecting the electromagnetic wave. Further, the semiconductor device comprises a substrate and an interface layer. The interface layer is arranged between the radiation element and/or the detection element and the substrate. A thermal conductivity of the radiation element and/or the detection element is different from a thermal conductivity of the interface layer.

## Description

### Field

Examples relate to semiconductor devices, a microelectromechanical system gas sensor and methods.

### Background

The sensing of environmental parameters, such as noise, sound, temperature and gases gains more and more importance within mobile devices, home automatization and the automotive sector. In a sensor device, mechanical and thermal couplings play a major role for cross-coupling and readout quality, such as for microelectromechanical system (MEMS) as well as environmental sensors and others. However, cross-coupling can have a negative impact on the performance of the sensor device. Therefore, there is a demand for an improved concept to reduce cross-coupling.

### Summary

This demand may be satisfied by the subject matter of the independent claims.

Some aspects of the present disclosure relate to a semiconductor device comprising a radiation element and a detection element. The radiation element comprises a radiation layer for radiating an electromagnetic wave. The detection element comprises a detection layer for detecting the electromagnetic wave. Further, the semiconductor device comprises a substrate and an interface layer. The interface layer is arranged between the radiation element and/or the detection element and the substrate. A thermal conductivity of the radiation element and/or the detection element is different from a thermal conductivity of the interface layer.

Some aspects of the present disclosure relate to a semiconductor device comprising a radiation element and a detection element. The radiation element comprises a radiation layer for radiating an electromagnetic wave. The detection element comprises a detection layer for detecting the electromagnetic wave. Further, the semiconductor device comprises a substrate and a cap layer. The cap layer is arranged above the radiation element and/or the detection element. A thermal conductivity of the radiation element and/or the detection element is different from a thermal conductivity of the cap layer.

Some aspects of the present disclosure relate to a MEMS gas sensor comprising a semiconductor device as described above.

Some aspects of the present disclosure relate to a method comprising forming a radiation element comprising a radiation layer for radiating an electromagnetic wave and a detection element comprising a detection layer for detecting the electromagnetic wave on a substrate. The method further comprises forming an interface layer on the radiation element or the detection element. A thermal conductivity of the radiation element and/or the detection element is different from a thermal conductivity of the interface layer. Further, the method comprises attaching the interface layer to a further substrate.

Some aspects of the present disclosure relate to a method comprising forming a radiation element comprising a radiation layer for radiating an electromagnetic wave and a detection element comprising a detection layer for detecting the electromagnetic wave on a substrate. The method further comprises forming a cap layer on the radiation element or the detection element. A thermal conductivity of the radiation element and/or the detection element is different from a thermal conductivity of the cap layer.

### Brief description of the Figures

Some examples of apparatuses and/or methods will be described in the following by way of example only, and with reference to the accompanying figures, in which
Figs. 1a-1c show schematic views of cross sections of semiconductor devices;
Fig. 2 shows a schematic view of a cross section of another example of a semiconductor device;
Figs. 3a-3d show schematic views of cross sections of other examples of a part of a semiconductor device;
Figs. 4a-4b show schematic views of cross sections of other examples of a part of a semiconductor device;
Figs. 5a-5c show schematic views of cross sections of other examples of a part of a semiconductor device;
Figs. 6a-6b show schematic views of cross sections of examples of a semiconductor device;
Fig. 7 shows a block diagram of a method for manufacturing a semiconductor device; and
Fig. 8 shows a block diagram of a method for manufacturing a semiconductor device.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e., only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

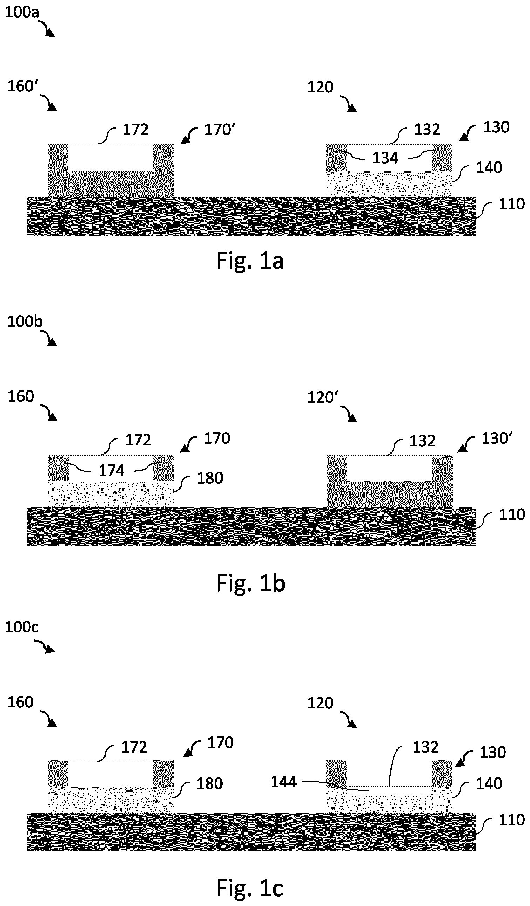

Figs. 1a-1c show schematic views of cross sections of semiconductor devices 100a, 100b, 100c. As can be seen in Fig. 1a the semiconductor device 100a comprises a substrate 110. Further, the semiconductor device 100a comprises a radiation element 130 and detection element 170'. The radiation element 130 comprises a radiation layer 132 configured to radiate an electromagnetic wave. The detection element 170' comprises a detection layer 172 configured to detect the electromagnetic wave. That is, the radiation element 130 may radiate an electromagnetic wave to be detected by the detection element 170'. For example, the radiation element 130 may be part of an emitter 120 and/or the detection element 170' may be part of a detector 160'.

The radiation element 130 may comprise a supporting layer 134, e.g., a semiconductor substrate or a semiconductor layer. The radiation element 130, e.g., the radiation layer 132, may be supported by the supporting layer 134. For example, the radiation layer 132 may comprise a membrane structure or may be a membrane structure, e.g., a membrane or a diaphragm. For example, the radiation element 130 may be a thermal MEMS, such as an infrared heater. That is, the radiation element 130 may be a thermally active component. The supporting layer 134 and the radiation layer 132 may be formed in one piece. That is, the radiation layer 132 may be formed from the supporting layer 134, e.g., a semiconductor substrate, for example, by etching a portion of the supporting layer to form the radiation layer 132. Alternatively, the radiation layer 132 may be attached to the supporting layer 134. Optionally or alternatively, the supporting layer 134 may comprise multiple sub-layers (i.e., the supporting layer 134 is not formed in one piece). For example, the radiation layer 132 may be formed in a sub-layer of the supporting layer 134. The supporting layer 134 and/or the radiation layer 132 may comprise or may be made of a semiconducting material such as silicon, silicon carbide, silicon germanium, for example. Alternatively, the supporting layer 134 and/or the radiation layer 132 may comprise or may be made of an insulating material such as silicon nitride or glass. That is, the detection element 130 may comprise or may be made of silicon nitride or glass.

The radiation element 130, e.g., the radiation layer 132, may be configured to radiate an electromagnetic wave. For example, the radiation layer 132 may be configured to radiate heat or thermal radiation, e.g., infrared radiation. The radiation layer 132 may be configured to radiate the electromagnetic wave in an operating range, e.g., a temperature range or wavelength range, of the detection layer 172. For example, the electromagnetic wave may be radiated at a first temperature range for operating the detection layer 172 for physically (i.e., according to a physical principle, e.g., the photoacoustic principle) detecting at least a first target gas between the radiation layer 132 and the detection layer 172.

For example, the radiation layer 132 may be configured to intermittently radiate the electromagnetic wave. The radiated electromagnetic wave may be absorbed, at least partially, by gas molecules which heat up accordingly. If the electromagnetic wave is no longer emitted by the radiation layer 132, no heat or thermal radiation can be absorbed anymore by the gas molecules, and they cool down again. This intermittent heating and cooling induces a pressure variation. This pressure variation may be detected by the detection layer 172 which may transduce the measured pressure variation into a corresponding measurement signal. That is, the detection layer 172 may be configured to detect the electromagnetic wave radiated by the radiation layer 132. Thus, the detection layer 172 may be configured to detect indirectly the electromagnetic wave radiated by the radiation layer 132. That is, the detection layer 172 may be configured to detect a pressure variation induced by the electromagnetic wave. In this case, the detection layer 172 may be part of a thermal sensor. Optionally or alternatively, the detection layer 172 may be configured to detect directly the electromagnetic wave radiated by the radiation layer 132. That is, the detection layer 172 may be configured to determine an absorption spectrum of the electromagnetic wave, for example. In this case, the detection layer 172 may be part of a direct absorption sensor.

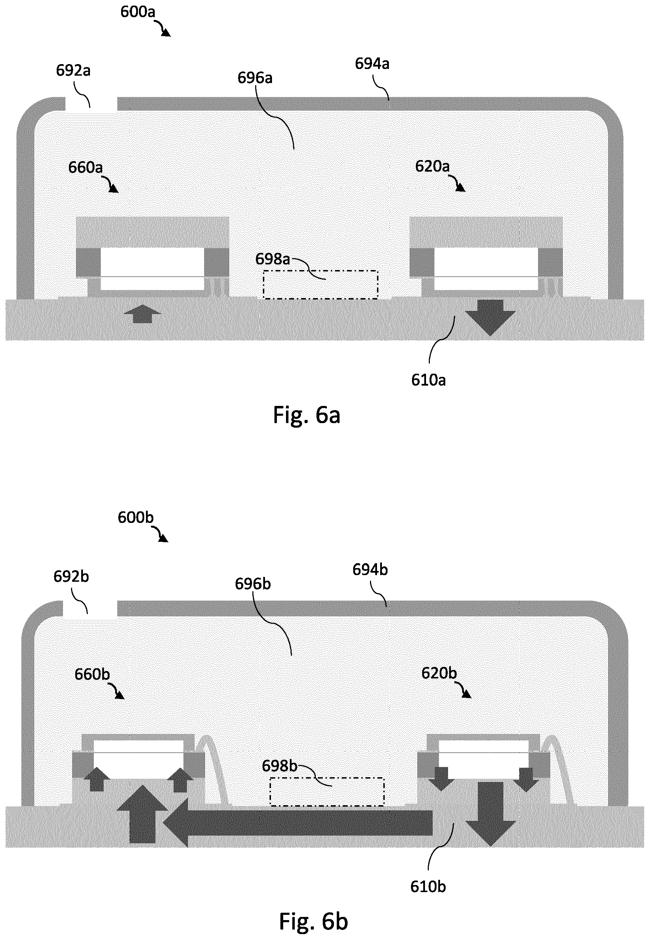

As can be seen in Fig. 1b, the detection element 170 may comprise a supporting layer 174, e.g., a semiconductor substrate or a semiconductor layer. The detection element 170, e.g., the detection layer 172, may be supported by the supporting layer 174. For example, the detection layer 172 may comprise or may be a microphone structure, e.g., a MEMS microphone, a pressure sensitive transducer, a piezo transducer, a capacitive sensor, a thermal sensitive structure, a mechanical strain sensitive structure and/or a magnetic field sensitive structure. For example, the detection element 170 may be a thermally sensitive component. Thus, the semiconductor device 100a, 100b, 100c may be used in a MEMS gas sensor, such as in a miniaturized photo acoustic spectrometer sensor or a thermally sensitive device (see Fig. 6).

The supporting layer 174 and the detection layer 172 may be formed in one piece. That is, the detection layer 172 may be formed from the supporting layer 174, e.g., a semiconductor substrate, for example, by etching a portion of the supporting layer to form the detection layer 172. Alternatively, the detection layer 172 may be attached to the supporting layer 174. Optionally or alternatively, the supporting layer 174 may comprise multiple sub-layers (i.e., the supporting layer 174 is not formed in one piece). For example, the detection layer 172 may be formed in a sub-layer of the supporting layer 174. The supporting layer 174 and/or the detection layer 172 may comprise or may be made of a semiconducting material such as silicon, silicon carbide, silicon germanium and/or a piezoelectric material such as lithium niobate, aluminum nitride, barium titanate, for example. Alternatively, the supporting layer 174 and/or the detection layer 172 may comprise or may be made of an insulating material such as silicon nitride or glass. That is, the detection element 170 may comprise or may be made of silicon nitride or glass.

The substrate 110 may be a printed circuit board or a lead frame, for example. Because the radiation element 130, 130' and the detection element 170, 170' may be thermally connected through the substrate 110, heat generated in the radiation element 130, 130' may affect the functionality of the detection element 170, 170'. The smaller the distance between the radiation element 130, 130'and the detection element 170, 170' become, the faster they can react to temperature changes (i.e., thermal capacity decreases and thermal modulation increases). Thermal modulation on the radiation element 130, 130' (caused by the process of radiating the electromagnetic wave) may create a modulated differential pressure. The modulated differential pressure may interfere with the optically generated photoacoustic signal, i.e., the induced pressure variation of the gas, and thus may negatively affect the detection element 170,170'. That is, thermal modulation on the radiation element 130, 130' (e.g., by a parasitic thermal signal) may conduct to the thermally sensitive detection element 170, 170' and may affect the sensitivity of the detection element 170, 170' due to cross-coupling. Therefore, the accuracy of the detection element 170, 170' may be decreased and/or an error of the detection element 170, 170' may be increased.

To reduce cross-coupling the radiation element 130 and/or the detection element 170 may be at least partially thermally decoupled. This can be achieved by use of an interface layer 140 (see Figs. 1a and 1c) and/or an interface layer 180 (see Figs. 1b and 1c) having a different thermal conductivity from the radiation element 130 or the detection element 170, respectively. For example, a thermal or mechanical interconnection for thermal stress sensitive devices as MEMS microphones, sensors or sensitive components may comprise the semiconductor device 100a, 100b, 100c comprising an interface layer 140, 180.

It is a finding of the inventors, that a defined conductive thermal interface may be necessary to adjust a thermal conductivity and a thermal path in a way to demodulate parasitic thermal signals (caused by the radiation element 130, 130' radiating the electromagnetic wave) from sensor measurement signals (the electromagnetic wave measured by the detection element 170, 170'). The conductive thermal interface may be provided by the interface layer 140, 180. Usually an emitter or a detector does not comprise a separate interface layer. A detector 160' and an emitter 120' do not normally have an interface layer (see Figs. 1a and Figs. 1b, respectively). A material between the radiation element 130'/the detection element 170' and the substrate 110 is identical to a material of the radiation element 130'/the detection element 170'. Therefore, parasitic thermal signal induced by an emitter 120' can negatively affect the detector 160'.

The conductive thermal interface, i.e., the interface layer 140, 180, can reduce cross-coupling between radiation element 130, 130' and detection element 170, 170'. For example, the interface layer 140, 180 may comprise a smaller or a larger thermal conductivity than the radiation element 130 and/or the detection element 170.

As can be seen in Fig. 1a, an interface layer 140 may be only arranged between the radiation element 130 and the substrate 110. Optionally or alternatively, an interface layer 180 may be only arranged between the detection element 170 and the substrate 110 (see Fig. 1b). Optionally or alternatively, an interface layer 140 may be arranged between the radiation element 130 and the substrate 110 and an interface layer 180 may be arranged between the detection element 170 and the substrate 110 (see Fig. 1c).

The interface layer 140, 180 may allow to provide a thermally isolated material stack (e.g., the emitter 120 or the detector 160) utilizing a thermally decoupling material (part of the interface layer 140, 180), e.g., an insulating material or a conductive material, with a thermal conductivity different from the thermal conductivity of the radiation element 130 and/or the detection element 170. The thermally decoupling material may demodulate the thermal oscillation caused by the radiation element 130 out of a frequency of the induced pressure variation to be detected by the detection element 170'. In this way, the modulated parasitic temperature oscillations of a material stack may be converted to a slow temperature drift by the thermally isolated material stack. That is, the thermally isolated material stack may be improved for a thermal path. Optionally the thermally isolated material stack may be combined with an arrangement as flip-chip mounting (e.g., see Figs. 1c, 3d, 4a, 4b, 5b, 5c, 6a). In this way, cross-coupling between radiation element 130, 130' and detection 170', 170 can be reduced in a facilitated way. The thermally isolated material stack design may be used for the emitter 120 and/or the detector 160.

For example, Fig. 1c shows an example of an emitter 120 assembled using flip-chip mounting. In this case, the interface layer 140 may be manufactured as a "cap layer" of an intermediate semiconductor device. The intermediate semiconductor device may be attached to the substrate 110 using flip-chip mounting. In this way, the "cap layer" of the intermediate semiconductor device may become the interface layer 140. Thus, the radiation element 130 may be supported by the interface layer 140. The radiation element 130 may face the interface layer 140.

The thermally isolated material stack comprising an interface layer 140, 180 may improve a performance of the detection element 170', 170 (due to a lower parasitic signal) and/or may allow to size-down/shrink the distance between the radiation element 130, 130' and the detection element 170', 170 due to thermal improvement possible.

For example, the interface layer 140, 180 may comprise or may be made of (i.e., the thermally decoupling material may comprise or may be made of) an insulating material, such as glass or silicon nitride or a conductive material such as doped silicon (if the radiation element 130'/detection element 170' comprises or is made of undoped silicon), monocrystalline silicon (if the radiation element 130'/detection element 170' comprises or is made of polycrystalline silicon) or a metal such as copper, gold, silver. A thickness of the interface layer 140, 180 may be at least 10 µm, or at least 30 µm, or at least 50 µm, or at least 100 µm and/or at most 1400 µm, or at most 1600 µm, or at most 1800 µm, or at most 2000 µm. A material of the (emitter) interface layer 140 may be different from a material of the (detector) interface layer 180, e.g., the (emitter) interface layer material may be an insulating material and the (detector) interface layer material may be a conductive material or a different insulating material. For example, the (emitter) interface layer 140 may comprise a conductive material and the (detector) interface layer 180 may comprise an insulating material. In this way, parameters of the emitter 120 and the detector 160 can be adjusted independently.

In an example, the thermal conductivity of the radiation element 130 and/or the detection element 170 may be different from the thermal conductivity of the interface layer 140, 180 by a factor of at least 5, or at least 7, or at least 9, or at least 10, or at least 12, or at least 14. In this way, the interface layer 140, 180 can thermally decouple the radiation element 130 and/or the detection element 170. A difference by a factor can mean that the thermal conductivity is either smaller by this factor or larger by this factor. For example, the thermal conductivity of the interface layer 140, 180 may be 10 times larger or ten times smaller than the thermal conductivity of the radiation element 130 or the detection element 170. For example, the radiation element 130 and/or the detection element 170 may comprise or may be made of silicon (150-170 W/(m*K)) and the interface layer 140, 180 may comprise or may be made of silicon nitride (10-50 W/(m*K)), glass (1,5 W/(m*K)) or a metal such as copper (398 W/(m*K)), gold (315 W/(m*K)), silver (429 W/(m*K)).For example, the radiation element 130 and/or the detection element may comprise or may be made of glass (e.g., the supporting layer 134, 174 may comprise or may be made of glass) and the interface layer 140, 180 may be made of silicon (e.g., doped silicon, undoped silicon, monocrystalline silicon or polycrystalline silicone). In this case, the interface layer 140, 180 may partially thermally decouple the radiation element 130/detection element 170 from the substrate 110. In this way, a cross-coupling can be reduced and a performance of the detection element 170, 170' can be improved.

To improve thermal decoupling the interface layer 140, 180 may be an insulating layer. In an example, the interface layer 140, 180 may have a thermal conductivity of less than 10 W/(m*K), or less than 7 W/(m*K), or less than 4 W/(m*K), or less than 2 W/(m*K). For example, the interface 140, 180 layer may comprise glass and/or a polymer such as acrylonitrile-butadiene-styrene (0.1-0.25 W/(m*K)), polycarbonate (0.2-0.35 W/(m*K)), polybutylene terephthalate (0.2-0.3 W/(m*K)). In this way, the interface layer 140, 180 can act as insulating layer. Therefore, a heat transfer between the radiation element 130/the detection element 170 and the substrate 110 may be strongly attenuated. Alternatively, the interface layer 140, 180 may be a conductive layer. In an example, the interface layer 140, 180 may have a thermal conductivity of at least 150 W/(m*K), or at least 170 W/(m*K), or at least 190 W/(m*K), or at least 200 W/(m*K) or at least 300 W/(m*K), or at least 380 W/(m*K). Decreasing or increasing the heat transfer between radiation element 130/detection element 170 and the substrate 110 may allow to improve a thermal decoupling of the radiation element 130 from the detection element 170, 170' and/or the detection element 170 from the radiation element 130, 130'. In this way, a cross-coupling can be reduced even further and a performance of the detection element 170, 170' can be improved.

In an example, the interface layer 140, 180 may comprise glass or may be made of glass. For example, the glass may comprise or may be made of silicon oxide such as silica quartz or phosphosilicate glass. In this way, the interface layer 140, 180 may act as insulating layer. Further, glass may facilitate a handling of the emitter 120/detector 160, such as attachment to the substrate 110. In addition, an interface layer 140, 180 comprising glass may provide an improved interface between interface layer 140, 180 and substrate 110, as in comparison to an adhesive. The interface layer 140, 180 may comprise a surface, which could be attached to the substrate 110. For example, an adhesive may not be required to attach an interface layer 140, 180, such as a glass layer or a silicon nitride layer, to a surface. In this way, an interface between the substrate 110 and the emitter 120/the detector 160 can be improved. For example, an inaccurate contact between interface layer 140 and surface due to the adhesive can be avoided.

In an example, the interface layer 140, 180 may be directly attached to the substrate 110. For example, the interface layer 140, 180 may be attached to the substrate 110 by bonding, e.g., glass to silicon anodic bonding, glass frit bonding, eutectic, transient liquid metal or metal to metal thermocompression bonding. For example, adhesive-free wafer bonding techniques, such as surface-activated bonding or hydrophilic bonding, can be used to attach the interface layer 140, 180 to the substrate 110. These methods rely on surface activation or modification to create a bond without the use of adhesives. Since the interface layer 140, 180 can be attached directly to the substrate 110, an interface between the emitter 120/the detector 160 and the substrate 110 can be improved.

As described above with reference to Fig. 1c, the interface layer 140, 180 may be a "cap layer" of an intermediate semiconductor device. In this case, the radiation layer 132 may face the interface layer 140, 180. That is, the radiation layer 132 may be formed on or in a surface of the radiation element 130 facing the interface layer 140, 180. In an example, the interface layer 140, 180 may comprise a cavity 144. Further, the radiation layer 132 may face the cavity. For example, the radiation layer 132 may be arranged above the cavity 144 to prevent a contact between interface layer 140, 180 and radiation layer 132. In this case, a thermally isolated material stack (comprising the interface layer 140, 180 and the radiation element 130) may be attached to the substrate 110 (e.g., using flip-chip mounting). Alternatively, the interface layer 140, 180 may be attached to the substrate 110 and the radiation element 130 may be attached to the interface layer 140, 180. That is, both the emitter 120 and the detector 160 can each be formed using flip-chip mounting or alternatively, by attaching the interface layer 140, 180 to the substrate 110 and by attaching the radiation element 130/detection element 170 to the interface layer 140, 180.

In an example, the interface layer 140, 180 may be attached to the radiation element 130 and/or the detection element 170. For example, the radiation element 130 may be an emitting layer 130. The emitting layer 130 may comprise the radiation layer 132. That is, the emitting layer 130 may be configured to radiate the electromagnetic wave. The emitting layer 130 may be formed separately from the interface layer 140. Thus, the emitting layer 130 may be attached to the interface layer 140. For example, the emitting layer 130 may be attached to the supporting layer 134 and the supporting layer 134 may be attached to the interface layer 140. Alternatively, the emitting layer 130 may be directly attached to the interface layer 140.

For example, the detection element 170 may be a measuring layer. The measuring layer 170 may comprise the detection layer 172. That is, the measuring layer 170 may be configured to measure the electromagnetic wave. The measuring layer 170 may be formed separately from the interface layer 180. Thus, the measuring layer 170 may be attached to the interface layer 180. For example, the measuring layer 170 may be attached to the supporting layer 174 and the supporting layer 174 may be attached to the interface layer 180. Alternatively, the measuring layer 170 may be directly attached to the interface layer 180.

As described above, the radiation element 130 may be a thermally active component and the detection element 170 may be a thermally sensitive component. Thus, in an example, the radiation element 130 or the detection element 170 may be electrically connected to the substrate 110 by a coupling element. For example, the radiation element 130 and the detection element 170 may be connected by multiple coupling elements to the substrate 110. The coupling element may be an electrical connection between the radiation element 130/the detection 170 and the substrate 110. In an example, the coupling element may comprise or may be a solder ball, a via, an electrically conductive adhesive and/or a wire bond.

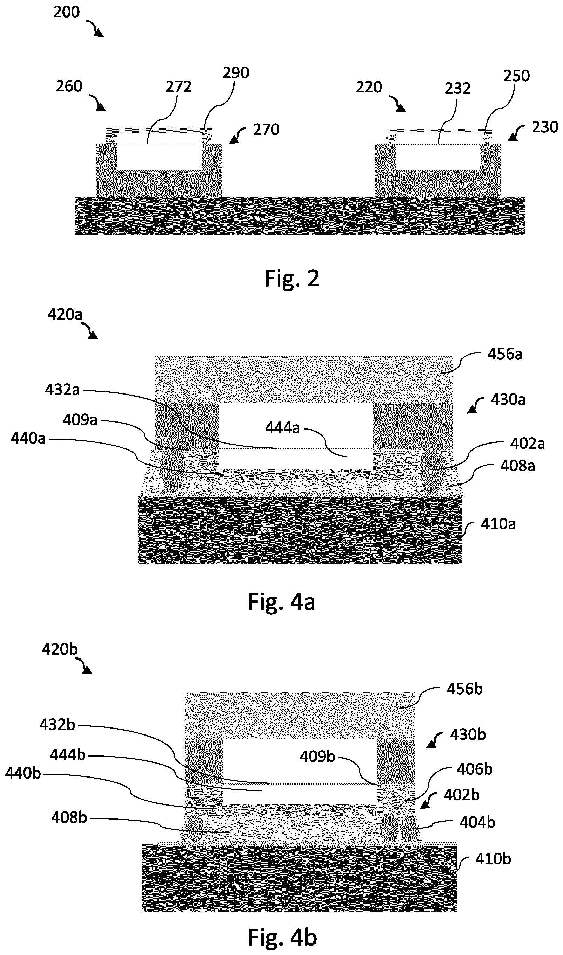

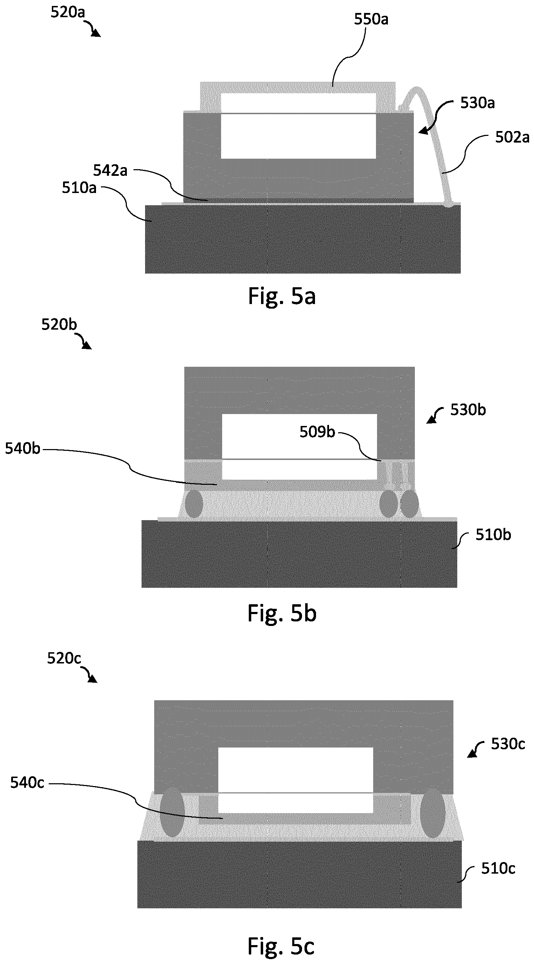

In an example, the semiconductor device 100a, 100b, 100c may further comprise an underfill layer arranged between the radiation element 130 or the detection element 170 and the substrate 110 (see also Figs. 4, 5b, 5c). The underfill layer may improve a stability of the emitter 120 and/or the detector 160. Further, the underfill layer may increase a design flexibility of the semiconductor device 100a, 100b, 100c. Further, a material of the underfill layer can be chosen depending on a thermal conductivity. That is, a thermal conductivity of the emitter 120/the detector 160 can be adjusted using the underfill layer. Thus, the thermal conductivity can be adjusted using the underfill layer during a back-end-of-line process. In this way, the thermal conductivity of the emitter 120/the detector 160 can be adjusted using front-end-of-line processes, e.g., bonding the interface layer 140, 170 on the substrate 110 and using back-end-of-line processes, e.g., forming the underfill layer.

In an example, the underfill layer may be arranged between the interface layer 140, 180 and the substrate 110. In an example, the interface layer 140, 180 may be at least partially embedded in the underfill layer. In an example, the semiconductor device 100a, 100b ,100c may further comprise a solder ball electrically coupling the radiation element or the detection element with the substrate. The solder ball may be partially embedded in the underfill layer. In an example, the solder ball may extend along a lateral dimension of the interface layer 140, 180.

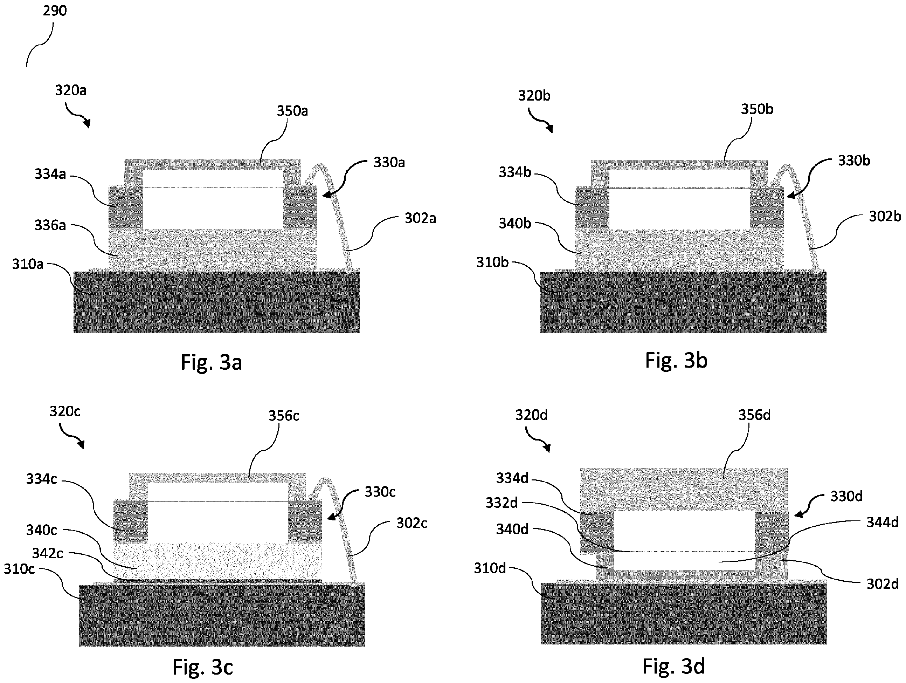

In an example, the semiconductor device 100a, 100b, 100c may further comprise a cap layer arranged above the radiation element 130 and/or the detection element 170. The cap layer is transparent for infrared light. The cap layer may cover the radiation element 130 and/or the detection element 170. The cap layer may not block or may not interfere with the radiated electromagnetic wave. The cap layer may further act to thermally decouple the radiation element 130 and/or the detection element 170. For example, a thermal conductivity of the cap layer may be different from a thermal conductivity of the radiation element and/or the detection element (e.g., see Figs. 2, 3b).

More details and aspects are mentioned in connection with the examples described below. The example shown in Fig. 1 may comprise one or more optional or additional features corresponding to one or more aspects mentioned in connection with the proposed concept or one or more examples described below (e.g., Fig. 2 - 8).

Fig. 2 shows a schematic view of a cross section of another example of a semiconductor device 200. The semiconductor device 200 comprises a substrate 210. Further, the semiconductor device 200 comprises a radiation element 230 and detection element 270. The radiation element 230 comprises a radiation layer 232 configured to radiate an electromagnetic wave. The detection element 270 comprises a detection layer 272 configured to detect the electromagnetic wave. That is, the radiation element 230 may radiate an electromagnetic wave to be detected by the detection element 270. For example, the radiation element 230 may be part of an emitter 220 and/or the detection element 270 may be part of a detector 260.

As described with reference to Fig. 1, arranging the radiation element 230 and the detection element 270 in a semiconductor device 200 may lead to cross-coupling. The cross-coupling can be reduced by an interface layer as described with reference to Fig. 1. Optionally or alternatively, the cross-coupling can also be reduced by a cap layer 250, 290 .

Thus, the semiconductor device 200 may comprise a cap layer 250, 290 arranged above the radiation element 230 and/or the detection element 270. A thermal conductivity of the radiation element 230 and/or the detection element 270 may be different from a thermal conductivity of the cap layer 250, 290. The cap layer 250, 290 may affect a heat generation and/or a heat distribution in the emitter 220 and/or the detector 260. Therefore, a heat transfer to the substrate 210 can be adjusted using the cap layer 250, 290. For example, the cap layer 250, 290 may cause an increased heat transfer towards the substrate 210 or a decreased heat transferred towards the substrate 210. In this way, undesired heat generated in the emitter 210 and transferred into the substrate 210 can be at least partially thermally decoupled from the intended electromagnetic wave radiated of the radiation element 230.

The cap layer 250, 290 may be a separate layer attached to the radiation element 230/the detection element 270. The above description (Fig. 1) of the interface layer also applies to the cap layer 250, 290. That is, the cap layer 250, 290 can have the same properties and parameters as the interface layer.

Optionally, the cap layer 250, 290 can be combined with an interface layer. In this case, the adjustment of heat transfer can be facilitated.

Fig. 2 shows only exemplary a cap layer 250 above the radiation element 230 and a cap layer 290 above the detection element 270. In other examples, a cap layer 250 or a cap layer 290 may be disposed only over the radiation element 230 or only over the detection element 270, respectively.

More details and aspects are mentioned in connection with the examples described above and/or below. The example shown in Fig. 2 may comprise one or more optional or additional features corresponding to one or more aspects mentioned in connection with the proposed concept or one or more examples described above (e.g., Fig. 1) and/or below (e.g., Fig. 3 -8).

Figs. 3a-3d show schematic views of cross sections of other examples of a part of a semiconductor device. Figs. 3a-3d show exemplary an emitter 320a, 320b, 320c, 320d with a three-layer stack, namely interface layer 336a, 340b, 340c, 340d, radiation element 330a, 330b, 330c, 330d comprising the supporting structure 334a, 334b, 334c, 334d and the cap layer 350a, 350b, 356c, 356d. The three-layer stack is an example. In other examples, the stack may comprise less layers, e.g., two layers (see Fig. 5) or more layers. Optionally, the interface layer 336a, 340b, 340c, 340d and/or the radiation element 330a, 330b, 330c, 330d may comprise multiple layers.

Fig. 3a shows an example of an emitter 320a. The emitter 320a may be part of a semiconductor device according to Fig. 2. The emitter 320a may comprise a substrate 310a, an interface layer 336a, a radiation element 330a and a cap layer 350a. The thermal conductivity of the interface layer 336a may be identical to the thermal conductivity of the radiation element 330a. The thermal conductivity of the radiation element 330a may be different from the thermal conductivity of the cap layer 350a. Thus, a thermally decoupling can be achieved using the cap layer 350a. The radiation element 330a may comprise a supporting layer 334a configured to support the radiation layer. Further, Fig. 3a shows a coupling element 302a, e.g., a wire bond 302a, configured to electrically connect the substrate 310a with the radiation element 330a. For example, the cap layer 350a may comprise or may be made of glass or a silicon nitride. The radiation element 330a and/or the interface layer 336a may comprise or may be made of semiconducting material such as silicon, silicon carbide, silicon germanium, for example.

The substrate 310a and the interface layer 336a may comprise or may be made of silicon and may be bonded together. For example, silicon to silicon bonding can be done by glass frit bonding, eutectic, transient liquid metal or metal to metal thermocompression bonding.

Fig. 3b shows an example of an emitter 320b. The emitter 320b may be part of a semiconductor device according to Fig. 1 and/or Fig. 2. The emitter 320b may comprise a substrate 310b, an interface layer 340b, a radiation element 330b and a cap layer 350b. The thermal conductivity of the interface layer 340b may be different from the thermal conductivity of the radiation element 330b. The thermal conductivity of the radiation element 330b may be different from the thermal conductivity of the cap layer 350b. Thus, a thermally decoupling can be achieved using the cap layer 350b and the interface layer 340b. The radiation element 330b may comprise a supporting layer 334b configured to support the radiation layer. Further, Fig. 3b shows a coupling element 302b, e.g., a wire bond 302b, configured to electrically connect the substrate 310b with the radiation element 330b. For example, the cap layer 350b and/or the interface layer 340b may comprise or may be made of glass or a silicon nitride. The radiation element 330b may comprise or may be made of semiconducting material such as silicon, silicon carbide, silicon germanium and/or a piezoelectric material such as lithium niobate, aluminum nitride, barium titanate, for example.

The interface layer 340b may be attached to the substrate 310b using bonding techniques, e.g., anodic bonding, glass frit bonding, eutectic, transient liquid metal or metal to metal thermocompression bonding.

Fig. 3c shows an example of an emitter 320c. The emitter 320c may be part of a semiconductor device according to Fig. 1. The emitter 320c may comprise a substrate 310c, an interface layer 340c, a radiation element 330c and a cap layer 356c. The thermal conductivity of the interface layer 340c may be different from the thermal conductivity of the radiation element 330c. The thermal conductivity of the radiation element 330c may be identical to the thermal conductivity of the cap layer 356c. Thus, a thermally decoupling can be achieved using the interface layer 340c. The radiation element 330c may comprise a supporting layer 334c configured to support the radiation layer. Further, Fig. 3c shows a coupling element 302c, e.g., a wire bond 302c, configured to electrically connect the substrate 310c with the radiation element 330c. For example, the interface layer 340c may comprise or may be made of glass or a silicon nitride. The radiation element 330c and/or the cap layer 356c may comprise or may be made of semiconducting material such as silicon, silicon carbide, silicon germanium, for example.

In contrast to Fig. 3b the interface layer 340c may be attached to the substrate 3 10c using an attachment layer 342c. For example, the attachment layer 342c may comprise or may be made of an adhesive or an elastomer.

Fig. 3d shows an example of an emitter 320d. The emitter 320d may be part of a semiconductor device according to Fig. 1. The emitter 320d may comprise a substrate 310d, an interface layer 340d, a radiation element 330d and a cap layer 356d. The thermal conductivity of the interface layer 340d may be different from the thermal conductivity of the radiation element 330d. The thermal conductivity of the radiation element 330d may be identical to the thermal conductivity of the cap layer 356d. Thus, a thermally decoupling can be achieved using the interface layer 340d. The radiation element 330d may comprise a supporting layer 334d configured to support the radiation layer. Further, Fig. 3d shows a coupling element 302d, e.g., a through substrate via such as a through glass via, configured to electrically connect the substrate 3 10d with the radiation element 330d. For example, the interface layer 340d may comprise or may be made of glass or a silicon nitride. The radiation element 330d and/or the cap layer 356d may comprise or may be made of semiconducting material such as silicon, silicon carbide, silicon germanium, for example.

As can be seen in Fig. 3d, the radiation layer 332d may face the interface layer 340d. The interface layer 340d may comprise a cavity 344c. The radiation layer 332d may face the cavity 344d. That is, a surface of the radiation element 330d on or in which the radiation element 332d is formed may face the interface layer 340d. Therefore, Fig. 3d shows an emitter 320d, which may be manufactured using flip-chip mounting.

The description of Figs. 3a-3d of the emitter 320a, 320b, 320c, 320d also applies to a detector.

Even if different features are shown in the individual Figs. 3a-3d, they can be combined with each other. For example, the emitter 320b according to Fig. 3b may comprise a through silicon via instead of a wire bond and optionally may be manufactured using flip-chip mounting or the semiconductor device 300d according to Fig. 3d may comprise a cap layer 356d comprising or made of glass or a silicon nitride.

Even if Fig. 1 and Fig. 2 show separated approaches for emitters and detectors for a semiconductor device, they can be combined. For example, a semiconductor device may comprise an emitter according to Fig. 3d and a detector according to Fig. 3a.

More details and aspects are mentioned in connection with the examples described above and/or below. The example shown in Fig. 3 may comprise one or more optional or additional features corresponding to one or more aspects mentioned in connection with the proposed concept or one or more examples described above (e.g., Fig. 1 - 2) and/or below (e.g., Fig. 4 - 8).

Figs. 4a-4b show schematic views of cross sections of other examples of a part of a semiconductor device. Fig. 4a shows an emitter 420a. The emitter 420a may be part of a semiconductor device according to Fig. 1. The emitter 420a may comprise a substrate 410a, an interface layer 440a, a radiation element 430a and a cap layer 456a. The emitter 420a may further comprise an optional underfill layer 408a. The underfill layer 408a may be arranged between the substrate 410a and the radiation element 430a. As can be seen in Fig. 4a, the underfill layer 408a may partially surround the interface layer 440a. That is, the interface layer 440a may be embedded in the underfill layer 408a.

The interface layer 440a may comprise a cavity 444a. The radiation layer 432a of the radiation element 430a may face the cavity 444a. That is, the emitter 420a may be manufactured using flip-chip mounting.

Further, the emitter 420a comprises a coupling element 402a. The coupling element 402a may be a solder ball or a cupper pillar. The coupling element 402a may be partially surrounded by the underfill material 408a. A solder ball or a cupper pillar may be advantageously if the interface layer 440a has a smaller cross-section than the radiation element 430a. For example, a thermally isolated material stack can be flip chip soldered onto the substrate 410a, e.g., a lead frame or a printed circuit board, by solder balls or cupper pillars. The coupling element 402b may be electrically connected with a conductive trace 409a, e.g., a solder cap arranged on top of the interface layer 440a and the underfill 408a. The conductive trace 409a may be electrically connected to the radiation layer 432a.The underfill 408a may increase a stability of the emitter 420a and/or may protect the coupling element 402a, e.g., prevent corrosion.

The interface layer 440a may comprise or may be made of glass or silicon nitride. The radiation element 430a and/or the cap layer 456a may comprise or may be made of semiconducting material such as silicon, silicon carbide, silicon germanium, for example.

Fig. 4b shows another example of an emitter 420b. The emitter 420b may be part of a semiconductor device according to Fig. 1. The emitter 420b may comprise a substrate 410b, an interface layer 440b, a radiation element 430b and a cap layer 456b. The emitter 420b may further comprise an optional underfill layer 408a. The underfill layer 408b may be arranged between the substrate 410b and the radiation element 430b. As can be seen in Fig. 4a, the underfill layer 408b may partially surround the interface layer 440b. That is, the interface layer 440b may be embedded in the underfill layer 408b.

The interface layer 440b may comprise a cavity 444b. The radiation layer 432b of the radiation element 430b may face the cavity 444b. That is, the emitter 420b may be manufactured using flip-chip mounting.

Further, the emitter 420a comprises a coupling element 402a. In contrast to Fig. 4b, the cross-section of the interface layer 440b may be at least identical to the cross-section of the radiation element 430b. Therefore, the coupling element 402a may comprise a through substrate via 406b, such as a through glass via 406b, and a solder ball 404b. The solder ball 404b may be partially surrounded by the underfill material 408b.

The through glass via 406 may have been formed, for example, through a glass "cap layer" of an intermediate semiconductor device. The intermediate semiconductor device can be flip chip mounted onto the substrate 410b, e.g., a lead frame or a printed circuit board, by solder balls or cupper pillars. The coupling element 402b may be electrically connected with a conductive trace 409b, e.g., a solder cap arranged on top of the interface layer 440b. The conductive trace 409b may be electrically connected to the radiation layer 432b.

The interface layer 440b may comprise or may be made of glass or silicon nitride. The radiation element 430b and/or the cap layer 456b may comprise or may be made of semiconducting material such as silicon, silicon carbide, silicon germanium, for example.

The description of Figs. 4a-4b of the emitter 420a, 420b also applies to a detector.

More details and aspects are mentioned in connection with the examples described above and/or below. The example shown in Fig. 4 may comprise one or more optional or additional features corresponding to one or more aspects mentioned in connection with the proposed concept or one or more examples described above (e.g., Fig. 1 - 3) and/or below (e.g., Fig. 5 - 8).

Figs. 5a-5c show schematic views of cross sections of other examples of a part of a semiconductor device. Figs. 5a-5c show exemplary an emitter 520a, 520b, 320c with a two-layer stack, namely interface layer 540a, 540b, 540c, 340d and radiation element 530a, 530b, 330c, 330d comprising the supporting structure and the cap layer.

Fig. 5a shows an emitter comparable to Fig. 3a. The emitter 520a may be part of a semiconductor device according to Fig. 2. The semiconductor device may comprise a substrate 510a, a radiation element 530a and a cap layer 550a. In contrast to Fig. 3a, the emitter 520a does not comprise a separated interface layer. The radiation element 530a may comprise the radiation layer and may be attached to the substrate 5 10a. For example, an attachment layer 542a may be used to attach the radiation element 530a to the substrate 510a. Attaching the radiation element 530a to the substrate 510a may facilitate a manufacturing process of a semiconductor device.

Further, Fig. 5a shows a coupling element 502a, e.g., a wire bond 502a, configured to electrically connect the substrate 510a with the radiation element 530a. For example, the cap layer 550a may comprise or may be made of glass or a silicon nitride. The radiation element 530a may comprise or may be made of semiconducting material such as silicon, silicon carbide, silicon germanium, for example.

Fig. 5b shows an emitter comparable to Fig. 4b. The emitter 520b may be part of a semiconductor device according to Fig. 1. The emitter 520b may comprise a substrate 5 10b, an interface layer 540b and a radiation element 530b. In contrast to Fig. 4b, the emitter 520b does not comprise a separated cap layer. The radiation element 530b may comprise the cap layer and may be attached to the interface layer 540b.

Fig. 5c shows an emitter 520c comparable to Fig. 4a. The emitter 520c may be part of a semiconductor device according to Fig. 1. The emitter 520c may comprise a substrate 510c, an interface layer 540c and a radiation element 530c. In contrast to Fig. 4a, the emitter 520c does not comprise a separated cap layer. The radiation element 530c may comprise the cap layer and may be attached to the interface layer 540b.

The description of Figs. 5a-5c of the emitter 520a, 520b, 520c also applies to a detector.

More details and aspects are mentioned in connection with the examples described above and/or below. The example shown in Fig. 5 may comprise one or more optional or additional features corresponding to one or more aspects mentioned in connection with the proposed concept or one or more examples described above (e.g., Fig. 1 - 4) and/or below (e.g., Fig. 6 - 8).

Figs. 6a-6b show schematic views of cross sections of examples of a semiconductor device 600a, 600b, e.g., a photoacoustic sensor 600a, 600b such as a MEMS gas sensor 600a, 600b or a non-dispersive infrared sensor. The photoacoustic sensor 600a, 600b or the non-dispersive infrared sensor may be manufactured using waver level bonding.

The photoacoustic sensor 600a shown in Fig. 6a may comprise an emitter 620a according to Fig. 3d and a detector 660a according to Fig. 3d. The interface layer may comprise a thermally decoupling material, e.g., an insulating material, with a thermal conductivity lower than the thermal conductivity of the radiation element and the detection element. In this way, a cross-coupling between emitter 620a and detector 660a can be reduced. As indicated by the arrows a heat transfer from the emitter 620a to the substrate may be less than a heat transfer from the substrate to the detector 660a. Thus, the photoacoustic sensor 600a may have a low thermal conduction.

Furthermore, the photoacoustic sensor 600a may comprise a substrate 610a, e.g., a printed circuit board or a lead frame. A cover 694a may be arranged on the substrate 610a. The cover 694a may be configured to cover the emitter 620a and the detector 660a. Further, the cover 694a may form the measurement cavity 696a. That is, the cover 694a may be configured to reflect the electromagnetic wave radiated from the emitter 620a. The cover 694a may provide a housing for the emitter 620a and the detector 660a. The cover 694a may comprise an opening 692a configured to provide a fluid communication with a surrounding, for example, for allowing an environmental gas and/or a target gas to enter the measurement cavity 696a. For example, the opening 692a may be arranged in a top wall (i.e., the wall facing the substrate 610a) of the cover 694a. Optionally or alternatively, the opening and/or another opening may be arranged in a side wall of the cover 694a.

The photoacoustic sensor 600a may further comprise a controller 698a, for example an integrated circuit, e.g., an ASIC (Application Specific Integrated Circuit). The controller 698a may be arranged inside or outside the measurement cavity 696a formed by the cover 694a. Thus, it is depicted in dashed lines in Figure 6a. The controller 698a may receive the measurement signal from the detector 660a and may process the measurement signal so as to identify the at least one target gas according to the photoacoustic principle.

The MEMS gas sensor 600b shown in Fig. 6b may comprise an emitter 620b according to Fig. 3a and a detector 660b according to Fig. 3a. The cap layer may comprise a thermally decoupling material, e.g., an insulating material, with a thermal conductivity lower than the thermal conductivity of the radiation element and the detection element. In this way, a cross-coupling between emitter 620a and detector 660a can be reduced. As indicated by the arrows a heat transfer from the emitter 620a to the detector 660a via the substrate may be increased by the cap layer. Thus, the MEMS gas sensor 600b may have a high thermal conduction.

Furthermore, the photoacoustic sensor 600b may comprise a substrate 610a, a cover 694b, a measurement cavity 696b, an opening 692b and a controller 698b as described with reference to Fig. 6a.

The photoacoustic sensor 600a, 600b, e.g., a MEMS gas sensor 600a, 600b, may be a subcomponent of a bigger system, for example of a photo acoustic spectrometer sensor or of a non-dispersive infrared sensor in which the MEMS gas sensor 600a, 600b may be used as an infrared emitter. However, the MEMS gas sensor 600a, 600b could also be a discrete or separate product. The MEMS gas sensor 600a, 600b may be used as a standalone multi-gas sensing cell, for example.

The semiconductor device 600a, 600b may provide a detector, e.g., a Si-microphone, packaged with wafer level bonding processes under a defined gas-sensing atmosphere, e.g., CO₂ or vacuum. The semiconductor device may provide a non-dispersive infrared sensor packaged with wafer level bonding processes. Typical photoacoustic sensors use silicon as bottom interface and top interface as connection to the sensing volume. Instead the semiconductor device 600a, 600b uses different materials to allow for adjustment of thermal conductivity to reduce cross-coupling.

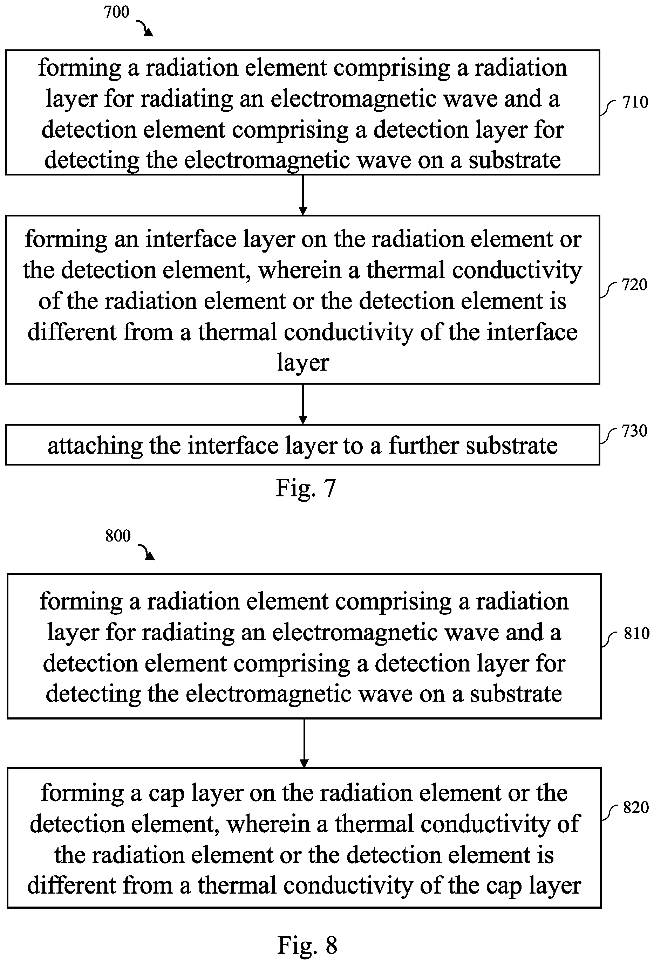

More details and aspects are mentioned in connection with the examples described above and/or below. The example shown in Fig. 6 may comprise one or more optional or additional features corresponding to one or more aspects mentioned in connection with the proposed concept or one or more examples described above (e.g., Fig. 1 - 5) and/or below (e.g., Fig. 7 - 8).

Fig. 7 shows a block diagram of a method 700 for manufacturing a semiconductor device. The method 700 comprises forming 710 a radiation element comprising a radiation layer for radiating an electromagnetic wave and a detection element comprising a detection layer for detecting the electromagnetic wave on a substrate. The method 700 further comprises 720 forming an interface layer on the radiation element or the detection element. A thermal conductivity of the radiation element and/or the detection element is different from a thermal conductivity of the interface layer. Further, the method 700 comprises attaching 730 the interface layer to a further substrate. A part of a or semiconductor device as described above, e.g., with reference to Figs. 1-6 can be formed according to method 700.

In an example, attaching the interface layer to the further substrate may comprise a flip-chip process. In this way, the interface layer can be manufactured as cap layer on top of the radiation element/the detection element and can be arranged as interface layer by flip-chip mounting. For example, a thermal MEMS, such as an infrared heater, may be encapsulated by wafer bonding using a cap wafer of glass or low thermal conductive material. For example, a photoacoustic sensor 600a, 600b may be manufactured using wafer level bonding.

In an example, the method 700 may further comprise forming an underfill layer with a back-end-of-line process. A thermal conductivity of the underfill layer is different from a thermal conductivity of the radiation element or the detection element. In this way, a thermal conductivity of an emitter/detector can be adjusted using a back-end-of-line process. That is, a thermal conductivity can be adjusted after front-end-of-line processing is finished, e.g., after glass to silicon bonding.

More details and aspects are mentioned in connection with the examples described above and/or below. The example shown in Fig. 7 may comprise one or more optional or additional features corresponding to one or more aspects mentioned in connection with the proposed concept or one or more examples described above (e.g., Fig. 1 - 6) and/or below (e.g., Fig. 8).

Fig. 8 shows a block diagram of a method 800 for manufacturing a semiconductor device. The method 800 comprises forming 810 a radiation element comprising a radiation layer for radiating an electromagnetic wave and a detection element comprising a detection layer for detecting the electromagnetic wave on a substrate. The method 800 further comprises forming 820 a cap layer on the radiation element or the detection element. A thermal conductivity of the radiation element and/or the detection element is different from a thermal conductivity of the cap layer. A part of a or a semiconductor device as described above, e.g., with reference to Figs. 1-6 can be formed according to method 800.

More details and aspects are mentioned in connection with the examples described above. The example shown in Fig. 8 may comprise one or more optional or additional features corresponding to one or more aspects mentioned in connection with the proposed concept or one or more examples described above (e.g., Fig. 1 - 7).

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, - functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

In the following, some examples of the proposed concept are presented:
An example (e.g., example 1) relates to a semiconductor device, comprising a radiation element comprising a radiation layer for radiating an electromagnetic wave and a detection element comprising a detection layer for detecting the electromagnetic wave, a substrate, and an interface layer arranged between the radiation element or the detection element and the substrate, wherein a thermal conductivity of the radiation element or the detection element is different from a thermal conductivity of the interface layer.

Another example (e.g., example 2) relates to a previous example (e.g., example 1) or to any other example, further comprising that the thermal conductivity of the radiation element or the detection element is different from the thermal conductivity of the interface layer by a factor of at least 10.

Another example (e.g., example 3) relates to a previous example (e.g., one of the examples 1 or 2) or to any other example, further comprising that the interface layer has a thermal conductivity of less than 2 W/(m*K).

Another example (e.g., example 4) relates to a previous example (e.g., one of the examples 1 to 3) or to any other example, further comprising that the interface layer comprises glass or is made of glass.

Another example (e.g., example 5) relates to a previous example (e.g., one of the examples 1 to 4) or to any other example, further comprising that the interface layer is directly attached to the substrate.

Another example (e.g., example 6) relates to a previous example (e.g., one of the examples 1 to 5) or to any other example, further comprising that the radiation element or the detection element is electrically coupled to the substrate by a coupling element.

Another example (e.g., example 7) relates to a previous example (e.g., example 6) or to any other example, further comprising that the coupling element comprises at least one of a solder ball, a via, an electrically conductive adhesive and a wire bond.

Another example (e.g., example 8) relates to a previous example (e.g., one of the examples 1 to 7) or to any other example, further comprising that the interface layer is directly attached to the radiation element or the detection element.

Another example (e.g., example 9) relates to a previous example (e.g., one of the examples 1 to 8) or to any other example, further comprising an underfill layer arranged between the radiation element or the detection element and the substrate.

Another example (e.g., example 10) relates to a previous example (e.g., example 9) or to any other example, further comprising that the underfill layer is arranged between the interface layer and the substrate.

Another example (e.g., example 11) relates to a previous example (e.g., example 9) or to any other example, further comprising that the interface layer is at least partially embedded in the underfill layer.

Another example (e.g., example 13) relates to a previous example (e.g., example 12) or to any other example, further comprising a solder ball electrically coupling the radiation element or the detection element with the substrate, wherein the solder ball is partially embedded in the underfill layer.

Another example (e.g., example 13) relates to a previous example (e.g., example 12) or to any other example, further comprising that the solder ball extends along a lateral dimension of the interface layer.

Another example (e.g., example 14) relates to a previous example (e.g., one of the examples 1 to 13) or to any other example, further comprising that the radiation element comprises a membrane.

Another example (e.g., example 15) relates to a previous example (e.g., one of the examples 1 to 14) or to any other example, further comprising that the detection element comprises at least one of a pressure sensitive transducer, a piezo transducer, a capacitive sensor, a thermal sensitive structure, a mechanical strain sensitive structure and a magnetic field sensitive structure.

Another example (e.g., example 16) relates to a previous example (e.g., one of the examples 1 to 15) or to any other example, further comprising a cap layer arranged above the radiation element or the detection element, the cap layer is transparent for infrared light.

An example (e.g., example 17) relates to a semiconductor device, comprising a radiation element comprising a radiation layer for radiating an electromagnetic wave or a detection element comprising a detection layer for detecting the electromagnetic wave, a substrate, and a cap layer arranged above the radiation element or the detection element, wherein a thermal conductivity of the radiation element or the detection element is different from a thermal conductivity of the cap layer.

An example (e.g., example 18) relates to a microelectromechanical system, MEMS, gas sensor, comprising a semiconductor device according to any one of the preceding examples.

An example (e.g., example 19) relates to a method, comprising forming a radiation element comprising a radiation layer for radiating an electromagnetic wave and a detection element comprising a detection layer for detecting the electromagnetic wave on a substrate, forming an interface layer on the radiation element or the detection element, wherein a thermal conductivity of the radiation element or the detection element is different from a thermal conductivity of the interface layer, and attaching the interface layer to a further substrate.

Another example (e.g., example 20) relates to a previous example (e.g., example 19) or to any other example, further comprising attaching the interface layer to the further substrate comprises a flip-chip process.

Another example (e.g., example 21) relates to a previous example (e.g., one of the examples 19 or 20) or to any other example, further comprising forming an underfill layer with a back-end-of-line process, wherein a thermal conductivity of the underfill layer is different from a thermal conductivity of the radiation element or the detection element.

An example (e.g., example 22) relates to a method, comprising forming a radiation element comprising a radiation layer for radiating an electromagnetic wave and a detection element comprising a detection layer for detecting the electromagnetic wave on a substrate, and forming a cap layer on the radiation element or the detection element, wherein a thermal conductivity of the radiation element or the detection element is different from a thermal conductivity of the cap layer.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A semiconductor device (100a; 100b; 100c), comprising:
a radiation element (130; 130') comprising a radiation layer (132) for radiating an electromagnetic wave and a detection element (170; 170') comprising a detection layer for detecting the electromagnetic wave;
a substrate (110); and
an interface layer (140; 180) arranged between the radiation element (130) or the detection element (170) and the substrate (110), wherein a thermal conductivity of the radiation element (130) or the detection element (170) is different from a thermal conductivity of the interface layer (140; 180).

2. The semiconductor device (100a; 100b; 100c) according to claim 1, wherein
the thermal conductivity of the radiation element (130) or the detection element (170) is different from the thermal conductivity of the interface layer (140; 180) by a factor of at least 10.

3. The semiconductor device (100a; 100b; 100c) according to any one of the preceding claims, wherein
the interface layer (140; 180) has a thermal conductivity of less than 2 W/(m*K).

4. The semiconductor device (100a; 100b; 100c) according to any one of the preceding claims, wherein
the interface layer (140; 180) comprises glass or is made of glass.

5. The semiconductor device (100a; 100b; 100c) according to any one of the preceding claims, wherein
the interface layer (140; 180) is directly attached to the substrate (110).

6. The semiconductor device (100a; 100b; 100c) according to any one of the preceding claims, wherein
the interface layer comprises a cavity (144) and wherein
the radiation layer (132) faces the cavity (144).

7. The semiconductor device (100a; 100b; 100c) according to any one of the preceding claims, wherein
the radiation element (130) or the detection element (170) is electrically coupled to the substrate (110) by a coupling element (302a; 302b; 302c; 302d).

8. The semiconductor device (100a; 100b; 100c) according to claim 7, wherein
the coupling element (302a; 302b; 302c; 302d) comprises at least one of a solder ball, a via, an electrically conductive adhesive and a wire bond.

9. The semiconductor device (100a; 100b; 100c) according to any one of the preceding claims, wherein
the interface layer (140; 180) is directly attached to the radiation element (130) or the detection element (170).

10. The semiconductor device (100a; 100b; 100c) according to any one of the preceding claims, further comprising
an underfill layer (408a; 408b) arranged between the radiation element (130) or the detection element (170) and the substrate (110).

11. The semiconductor device according to any one of the preceding claims, further comprising
a cap layer (350a; 350b; 356c; 356d) arranged above the radiation element (130) or the detection element (170), the cap layer (350a; 350b; 356c; 356d) is transparent for infrared light.

12. A semiconductor device, comprising:
a radiation element (230) comprising a radiation layer (232) for radiating an electromagnetic wave or a detection element (270) comprising a detection layer (272) for detecting the electromagnetic wave;
a substrate (210); and
a cap layer (250, 290) arranged above the radiation element (230) or the detection element (270), wherein a thermal conductivity of the radiation element (230) or the detection element (270) is different from a thermal conductivity of the cap layer (250; 290).

13. A microelectromechanical system, MEMS, gas sensor, comprising:
a semiconductor device according to any one of the preceding claims.

14. A method, comprising:
forming a radiation element comprising a radiation layer for radiating an electromagnetic wave and a detection element comprising a detection layer for detecting the electromagnetic wave on a substrate;
forming an interface layer on the radiation element or the detection element, wherein a thermal conductivity of the radiation element or the detection element is different from a thermal conductivity of the interface layer; and
attaching the interface layer to a further substrate.

15. A method, comprising:
forming a radiation element comprising a radiation layer for radiating an electromagnetic wave and a detection element comprising a detection layer for detecting the electromagnetic wave on a substrate; and
forming a cap layer on the radiation element or the detection element, wherein a thermal conductivity of the radiation element or the detection element is different from a thermal conductivity of the cap layer.
